# EUROPÄISCHE PATENTSCHRIFT

(11) **EP 0 780 978 B1**
(45) Veröffentlichungstag und Bekanntmachung des Hinweises auf die Patenterteilung: **23.06.2004**
(21) Anmeldenummer: 96120197.7
(22) Anmeldetag: 16.12.1996
(51) Int. Cl.: H03K 17/687, H03K 3/356

(54) **Elektrische Schaltvorrichtung**
Electrical switching device
Dispositif de commutation électrique

(30) Priorität: 20.12.1995 DE 19547768
(43) Veröffentlichungstag der Anmeldung: 25.06.1997
(73) Patentinhaber: SGS-THOMSON MICROELECTRONICS GMBH, 85630 Grasbrunn (DE)
(72) Erfinder: John, Udo, 85586 Poing (DE)
(74) Vertreter: Hirsch, Peter, Dipl.-Ing.

(56) Entgegenhaltungen:
- US-A- 4 795 917
- US-A- 4 996 443
- PATENT ABSTRACTS OF JAPAN vol. 018, no. 109 (E-1513), 22. Februar 1994 & JP 05 308274 A (MATSUSHITA ELECTRIC IND CO LTD), 19. November 1993
- PATENT ABSTRACTS OF JAPAN vol. 017, no. 418 (E-1408), 4. August 1993 & JP 05 083104 A (NEC CORP), 2. April 1993

## Beschreibung

Die Erfindung betrifft eine elektrische Schaltvorrichtung mit den Merkmalen des Oberbegriffs des Anspruchs 1. Eine solche Schaltvorrichtung ist aus PATENT ABSTRACTS OF JAPAN, vol. 018, no. 109 (E 1513), 22. Februar 1994 (JP-A-05-308274) bekannt.

Es gibt Anwendungen, bei denen eine elektrische Last mittels eines hochpotentialseitigen, also auf der Seite hohen Potentials der Last liegenden, Schalters in Form eines NMOS-Transistors, also eines N-Kanal-MOS-Transistors, geschaltet wird. Bei einem hochpotentialseitig angeordneten NMOS liegt dessen Source üblicherweise an der hochpotentialseitigen Versorgungsspannungsquelle. Um den NMOS-Transistor leitend schalten zu können, muß dessen Gate eine Steuerspannung zugeführt werden, die um mindestens den zum Leiten dieses Transistors führenden Einschaltspannungsschwellenwert über der an dessen Source befindlicher Spannung liegen muß. D.h., dem Gate dieses NMOS-Transistors muß eine Steuerspannung zugeführt werden, die höher ist als die hochpotentialseitige Versorgungsspannung. Zu diesem Zweck wird eine Spannungserhöhungsschaltung benötigt, beispielsweise in Form einer Bootstrap-Schaltung, eines induktiven Gleichspannungs-Gleichspannungs-Konverters oder einer Ladungspumpschaltung. Für kostengünstige integrierte Schaltungen verwendet man am liebsten eine Ladungspumpschaltung, da sie keine externen Komponenten benötigt. Wenn die integrierte Schaltung mit niedrigen Versorgungsspannungen auskommem muß, muß dafür Sorge getragen werden, daß man zu minimalen internen Spannungsabfällen kommt.

Herkömmliche Ladungspumpschaltungen weisen eine T-Schaltung mit zwei in Reihe geschalteten Dioden im Längszweig und einem dazwischen befindlichen Pumpkondensator im Querzweig auf. Die eine Diode ist auf ihrer vom Pumpkondensator abliegenden Seite mit einer Versorgungsspannungsquelle verbunden und läßt Ladespannung zum Kondensator durch, ohne daß dieser wieder über die Versorgungsspannungsquelle entladen werden könnte. Die zweite Diode dient der Entkopplung des Lade- oder Pumpkondensators von einer Last, die an das vom Pumpkondensator abliegende Ende der zweiten Diode angeschlossen wird. Bei der herkömmlichen Ladungspumpschaltung läßt sich daher ein Spannungsabfall gleich einem zweifachen Diodenspannungsabfall nicht vermeiden.

Man könnte nun Schalter wie DMOS-Transistoren anstelle von Dioden verwenden. Allerdings müßte man solche Schalter ihrerseits mittels einer zusätzlichen Ladungspumpschaltung treiben. Das Schalten solcher Schalttransistoren zu Erwirkung einer Gleichrichtung, die bei der herkömmlichen Ladungspumpschaltung von den Dioden bewirkt wird, führt zu einer Erhöhung von EMR (elektromagnetische Störstrahlung) im Bereich der Schaltgrundfrequenz.

Solche Probleme überwindet eine aus der JP 5-83104A bekannte elektrische Schaltvorrichtung mit einer einen Schaltsteueranschluß aufweisenden Schaltereinrichtung; mit einer zwischen einen ersten Spannungsquellenanschluß und einen zweiten Spannungsquellenanschluß einer Spannungsquelle geschalteten Steuerschaltung, die einen mit einem binären Schaltsteuersignal beaufschlagbaren Steuersignaleingang und einen auf den Schaltsteueranschluß der Schaltereinrichtung wirkenden Schaltsignalausgang aufweist und zwei zueinander parallel geschaltete Steuerschaltungszweige enthält, die je eine Reihenschaltung mit einem ersten Schalter, einem für den ersten Schalter als schaltbare Lastimpedanz dienenden zweiten Schalter und einem zwischen erstem Schalter und zweitem Schalter befindlichen Schaltungsknoten aufweisen, wobei der Schaltsignalausgang mit dem einen der beiden Schaltungsknoten verbunden ist, die zweiten Schalter je einen Lastimpedanzschaltsteueranschluß aufweisen und dadurch kreuzgekoppelt sind, daß deren Lastimpedanzschaltsteueranschlüsse mit dem Schaltungsknoten des je anderen Steuerschaltungszweiges verbunden sind, die ersten Schalter mittels des Schaltsteuersignals gegenläufig leitend und sperrend schaltbar sind, derart, daß dann, wenn einer der beiden ersten Schalter leitend geschaltet ist, der jeweils andere erste Schalter sperrend geschaltet ist und umgekehrt, und die zweiten Schalter aufgrund ihrer Kreuzkopplung miteinander und aufgrund ihrer Reihenschaltung mit den ersten Schaltern einerseits gegenläufig zueinander leitend und sperrend schaltbar sind, derart, daß dann, wenn einer der beiden zweiten Schalter leitend geschaltet ist, der jeweils andere zweite Schalter sperrend geschaltet ist und umgekehrt, und andererseits gegenläufig zu den ersten Schaltern leitend und sperrend schaltbar sind, derart, daß in jedem Steuerschaltungszweig dann, wenn dessen erster Schalter leitend geschaltet ist, dessen zweiter Schalter sperrend geschaltet ist und umgekehrt.

Diese Schaltereinrichtung der bekannten Schaltvorrichtung erzeugt im leitenden Zustand praktisch keinen Spannungsabfall, da ein leitend geschalteter MOS-Transistor, durch welchen die Schaltereinrichtung vorzugsweise gebildet wird, nur eine sehr geringe Impedanz aufweist. Aufgrund der Ansteuerung der Schaltereinrichtung mit einer Steuerschaltung der oben genannten Art wird zum Leitend-Schalten der Schaltereinrichtung keine höhere Spannung benötigt als diejenige Spannung, welche von der Schaltereinrichtung geschaltet wird.

Wenn man passive Schaltungskomponenten, wie Dioden, durch aktive Schaltungskomponenten wie Transistorschalter ersetzt, kommt es im allgemeinen zu zusätzlichem Leistungsverbrauch. Dies ist nicht der Fall bei der oben genannten Schaltvorrichtung, deren Steuerschaltung derart aufgebaut ist, daß sie das Schalten der Schaltereinrichtung leistungslos bewirkt. Denn in jedem der beiden Steuerschaltungszweige ist immer einer der Schalter nicht-leitend geschaltet.

Vorzugsweise sind sowohl die Schaltereinrichtung als auch die Schalter der Steuerschaltung durch MOS-Transistoren gebildet. Nun kann es vorkommen, daß an den Schaltungsknoten, also auch am Gate des die Schaltereinrichtung bildenden MOS-Transistors, unerwünscht hohe Spannungen auftreten, die die MOS-Transistoren beeinträchtigen. Um den die Schaltereinrichtung bildenden MOS-Transistor und die die zweiten Schalter bildenden, auf der Hochpotentialseite befindlichen MOS-Transistoren vor schädlich hohen Spannungen zu schützen, ist nach der eingangs genannten JP'274 in jedem der Steuerschaltung zwischen dem den ersten Schalter bildenden MOS-Transistor und dem den zweiten Schalter bildenden MOS-Transistor ein Schutztransistor, vorzugsweise in Form eines weiteren MOS-Transistors, vorgesehen, der mittels einer zwischen die Hochpotentialseite der Spannungsquelle und das Gate des Schutztransistors geschalteten Vorspannungsquelle dauerhaft leitend gehalten wird. Die an den Schaltungsknoten der beiden Steuerschaltungszweige und damit am Gate des die Schaltereinrichtung bildenden MOS-Transistors und an den die zweiten Schalter bildenden MOS-Transistoren auftretenden Spannungen können daher maximal so groß sein wie die Differenz zwischen dem Spannungswert der Vorspannungsquelle und dem Einschaltschwellenwert der Gate-Source-Spannung des jeweiligen Schutztransistors. Durch geeignete Bemessung der Vorspannungsquelle kann auf diese Weise dafür gesorgt werden, daß an allen Schaltungskomponenten, die auf der Hochpotentialseite der Schutztransistoren liegen, nur verträgliche Spannungswerte auftreten können.

Wenn die hochpotentialseitige Pumpspannung so weit abfällt, daß die Diode in dem Steuerschaltungszweig der mit dem Gate des die Schaltereinrichtung bildenden MOS-Transistors verbunden ist, sperrt, gibt es für den Fall, daß der erste Schalter dieses Steuerschaltungszweiges sperrend geschaltet ist, sowohl auf der Hochpotentialseite als auch auf der Niederpotentialseite des Gates des die Schaltereinrichtung bildenden MOS-Transistors ein sperrendes Element, nämlich die Diode bzw. den ersten Schalter dieses Steuerschaltungszweiges. Als Folge davon ergibt sich am Gate dieses MOS-Transistors ein undefiniertes Potential. In Abhängigkeit von Kapazitäten, Leckströmen und parasitären Effekten könnte es zu einem inversen Leiten des die Schaltereinrichtung bildenden MOS-Transistors kommen, obwohl sich dieser im Sperrzustand befinden sollte.

Aufgabe der Erfindung ist es, dieses inverse, Leiten der Schaltereinrichtung zu vermeiden.

Nach dem Anspruch 1 löst die die Erfindung diese Aufgabe durch einen Sicherheitstransistor, dessen Haupstrecke zwischen den Schaltsteueranschluß der Schaltereinrichtung und den Lastanschluß geschaltet und dessen Steuerelektrode an den hochpotentialseitigen Pumpspannungsanschluß angeschlossen ist und der im leitenden Zustand die Iastkapazitätsspannung an das Gate des die Schaltereinrichtung bildenden MOS-Transistors legt, so daß ein inverses Leiten dieses MOS-Transistors verhindert wird.

Ausführungsformen und Weiterbildungen der Erfindung sind den Unteransprüchen entnehmbar.

Die erfindungsgemäße Schaltvorrichtung ist vielseitig einsetzbar. Bei einer Anwendungsmöglichkeit werden die beiden Dioden einer herkömmlichen Ladungspumpschaltung je durch eine erfindungsgemäße Schaltvorrichtung ersetzt. Man kann die erfindungsgemäße Schaltvorrichtung aber auch zur Steuerung eines hochpotentialseitigen MOS-Schalttransistors verwenden. Man kann aber einen solchen hochpotentialseitigen MOS-Schalttransistor auch durch die erfindungsgemäße Schaltvorrichtung ersetzen.

Wenn die erfindungsgemäße Schaltvorrichtung zum Durchschalten einer Pumpspannung zu einer kapazitiven Last durchgeschaltet wird, beispielsweise zum Gate eines hochpotentialseitigen NMOS-Schalttransistors, kann es vorkommen, daß die Pumpspannung unter den Momentanwert der Spannung über der kapazitiven Last abfällt. MOS-Transistoren, wie sie für die zweiten Schalter verwendet werden, weisen parasitäre Source-Substrat-Dioden (im folgenden SSD genannt) auf, über welche die abgesunkene Pumpspannung auf das Gate des die Schaltereinrichtung bildenden MOS-Transistors gelangen könnte, so daß dieser aufgrund der höheren Ladespannung der kapazitiven Last unerwünschterweise in einen invers leitenden Zustand gelangen könnte. Um dies zu verhindern, ist bei einer bevorzugten Ausführungsform in jedem Steuerschaltungszweig zwischen der Pumpspannungsquelle und dem zweiten Schalter eine Diode angeordnet, welche eine Pumpspannung, die auf Werte unterhalb der Lastkapazitätsspannung abgesunken ist, vom Gate des die Schaltereinrichtung bildenden MOS-Transistors fernhält.

Die Erfindung wird nun anhand von Ausführungsformen näher erläutert. In den Zeichnungen zeigen:
- Fig. 1: ein Schaltbild einer bevorzugten Ausführungsform einer erfindungsgemäßen Schaltvorrichtung;
- Fig. 2: eine Impedanzkennlinie der Schaltvorrichtung nach Fig. 1, wenn diese leitend geschaltet ist;
- Fig. 3: Impedanzkennlinien der Schaltvorrichtung nach Fig. 1, wenn diese nicht-leitend geschaltet ist;
- Fig. 4a: eine herkömmliche Ladungspumpschaltung mit Dioden;
- Fig. 4b: eine Ladungspumpschaltung dieser Art, bei welcher die Dioden durch eine erfindungsgemäße Schaltvorrichtung ersetzt sind;
- Fig. 5a: einen hochpotentialseitigen MOS-Transistor mit herkömmlicher EIN/AUS-Steuerung;
- Fig. 5b: einen derartigen hochpotentialseitigen MOS-Transistor mit einer EIN/AUS-Steuerung mittels einer erfindungsgemäßen Schaltvorrichtung;
- Fig. 6a: einen herkömmlichen hochpotentialseitigen MOS-Schalter; und
- Fig. 6b: eine Schaltung, bei welcher der MOS-Schalter der Fig. 6a durch eine erfindungsgemäße Schaltvorrichtung ersetzt ist.

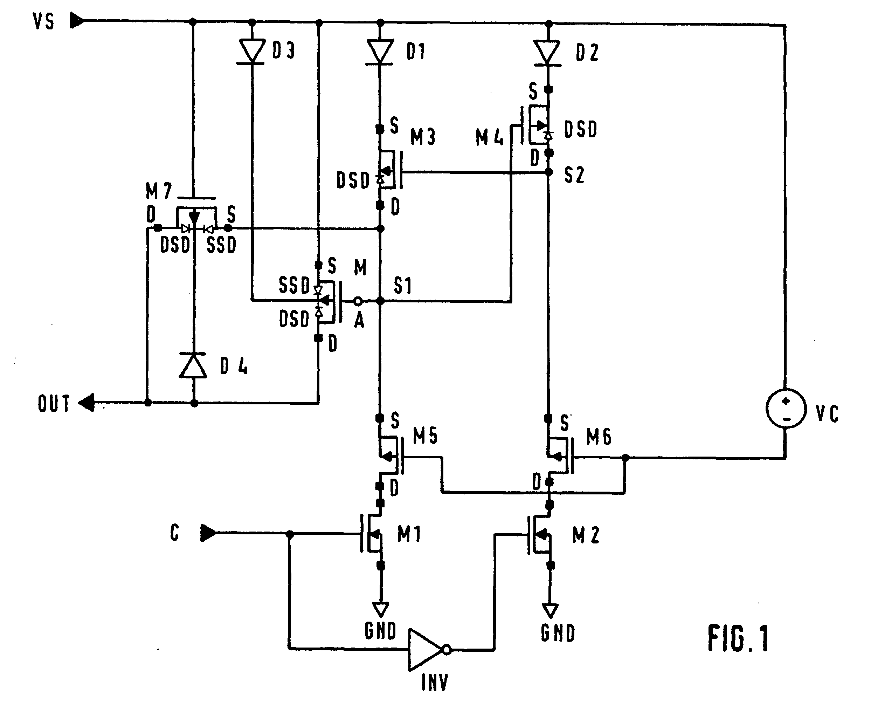

Eine Ausführungsform einer erfindungsgemäßen Schaltvorrichtung, wie sie in Fig. 1 gezeigt ist, weist einen Versorgungsspannungseingang VS, einen Ausgang OUT, an den eine zu schaltende Last anschließbar ist, und einen Steuersignaleingang C auf. Zwischen VS und OUT ist eine Schaltereinrichtung in Form eines P-Kanal-MOS-Transistors M geschaltet, wobei dessen Source S mit VS und dessen Drain D mit OUT verbunden ist.

Das Gate von M ist an einen Schaltsignalausgang A einer Steuerschaltung angeschlossen, mittels welcher M in Abhängigkeit davon, ob am Steuersignaleingang C ein Binärwert "1" bzw. H oder ein Binärwert "0" oder L anliegt, leitend oder sperrend geschaltet wird. Die Steuerschaltung ist zwischen den Versorgungsspannungseingang VS und einen Masseanschluß GND geschaltet. Die Steuerschaltung umfaßt zwei parallel zueinander geschaltete Steuerschaltungszweige. Jeder dieser beiden Steuerschaltungszweige weist je eine Reihenschaltung mit einem ersten Schalter M1 bzw. M2 auf der Niederpotential- oder Masseseite, einen für den ersten Schalter M1 bzw. M2 als schaltbare Lastimpedanz dienenden zweiten Schalter M3 bzw. M4 auf der Hochpotentialseite, einen Schutztransistor M5 bzw. M6 zwischen erstem und zweitem Schalter und eine Diode D1 bzw. D2 zwischen dem zweiten Schalter und VS auf. Bei der dargestellten Ausführungsform sind sowohl die beiden ersten Schalter M1 und M2 als auch die beiden zweiten Schalter M3 und M4 durch MOS-Transistoren gebildet.

Die Gateanschlüsse von M1 und M2 sind mit dem Steuersignaleingang C verbunden, und zwar der Gateanschluß von M1 direkt und der Gateanschluß von M2 über einen Inverter INV. Die Gateanschlüsse der Schutztransistoren M5 und M6 sind gemeinsam über eine Vorspannungsquelle VC an den Versorgungspannungseingang VS angeschlossen. Dabei ist der positive Anschluß von VC mit VS und der negative Anschluß von VC mit den Gateanschlüssen von M5 und M6 verbunden.

Zwischen den Transistoren M3 und M5 des ersten Steuerschaltungszweiges befindet sich ein erster Schaltungsknoten S1. Zwischen den Transistoren M4 und M6 des zweiten Steuerschaltungszweiges befindet sich ein zweiter Schaltungsknoten S2.

Die als zweite Schalter M3 und M4 dienenden MOS-Transistoren sind kreuzgekoppelt derart, daß der Gateanschluß von M3 mit dem Schaltungsknoten S2 und der Gateanschluß von M4 mit dem Schaltungsknoten S1 verbunden ist.

Zwischen OUT und S1 ist ein Sicherheitstransistor M7 in Form eines MOS-Transistors geschaltet. Dessen Drainanschluß D ist mit OUT verbunden, während dessen Source S mit S1 verbunden ist. Der Gateanschluß von M7 ist mit VS verbunden.

Normalerweise sind bei einem MOS-Transistor dessen Source und dessen Substrat elektrisch miteinander verbunden, wie es in Fig. 1 für die beiden Schalter M3 und M4 sowie für die beiden Schutztransistoren M5 und M6 dadurch symbolhaft dargestellt ist, daß deren Substratpfeile mit dem Sourceanschluß S des jeweiligen Transistors verbunden sind. Die Transistoren M und M7 unterscheiden sich von diesem Normalfall dadurch, daß deren Bulk- oder Substratanschlüsse und deren Sourceanschlüsse elektrisch voneinander getrennt und mit separaten Kontakten versehen sind. Daher sind bei diesen beiden Transistoren M und M7 die Substratpfeile in Form eines vierten Anschlusses dargestellt, der im Fall des Transistors M über eine Diode D3 mit VS und im Fall des Transistors M7 über eine Diode D4 mit OUT verbunden ist.

Bei den Dioden D1 und D2 handelt es sich um Diffusionsdioden, während die Dioden D3 und D4 durch Schottky-Dioden gebildet sind. Dabei liegen die Anoden der drei Dioden D1, D2 und D3 am Versorgungsspannungseingang VS, während die Anode der Diode D4 an OUT liegt.

Die Transistoren M1 und M2 sind N-Kanal-MOS-Transistoren. Die restlichen Transistoren M und M3 bis M7 sind P-Kanal-MOS-Transistoren.

MOS-Transistoren weisen parasitäre Dioden auf, die in Fig. 1 bei denjenigen Transistoren eingezeichnet sind, bei welchen sie eine Rolle für die später erläuterte Funktion der in Fig. 1 gezeigten Schaltvorrichtung haben. Diese parasitären Dioden bilden einerseits eine Diodenstrecke vom Drainanschluß zum Substratanschluß, hier Drain-Substrat-Diode-DSD genannt, und andererseits eine Diodenstrecke vom Sourceanschluß zum Substratanschluß, hier Source-Substrat-Diode-SSD genannt. In der Regel sind die Sourcezone und eine Substratkontaktierungszone elektrisch miteinander verbunden, und zwar üblicherweise dadurch, daß sie eine gemeinsame Kontaktierungsmetallisierung aufweisen. Diese schließt die parasitäre Source-Substrat-Diode SSD kurz, wie dies für die Transistoren M3 und M4 symbolisch dargestellt ist. Deren Drain-Substrat-Diode DSD stellt daher eine parasitäre Verbindung zwischen Drain und Source eines solchen Transistors dar.

Sind dagegen die Sourcezone und die Substratkontaktierungszone voneinander elektrisch getrennt, wie dies der Fall für die Transistoren M und M7 ist, bestehen parasitäre Verbindungen zwischen Drain und Substrat einerseits und Substrat und Source andererseits über die parasitären Drain-Substrat-Dioden DSD bzw. die parasitären Source-Substrat-Dioden SSD.

Bei entsprechenden Spannungsverhältnissen innerhalb der Schaltung können solche parasitären Dioden leiten und dazu führen, daß die eigentlichen Leit- und Sperr-Funktionen von MOS-Transistoren verfälscht werden.

Die Vorspannungsquelle VC weist einen derartigen Spannungswert auf, daß die Schutztransistoren M5 und M6 dauerhaft leiten. Über den Gate-Source-Strecken dieser Transistoren liegt daher eine Gate-Source-Spannung, die mindestens so groß ist wie die zum Leiten dieser Transistoren erforderliche Schwellenwertspannung. An den Sourceanschlüssen S der beiden Transistoren M5 und M6 liegt daher maximal eine Spannung gleich der Differenz zwischen dem Spannungswert von VC und der Schwellenwertspannung der Transistoren M5 und M6. Geht man beispielsweise von einer Schwellenwertspannung von 2V und einem Spannungswert der Vorspannungsquelle VC von 10V aus, tritt an den Sourceanschlüssen von M5 und M6 eine Spannung von höchstens 8V auf. Dies auch dann, wenn der Versorgungsspannungseingang VS auf viel höheren Spannungen liegen sollte. Die Schutztransistoren M5 und M6 schützen daher sowohl das Gate von M als auch die auf der Hochpotentialseite der Schutztransistoren M5 und M6 liegenden Komponenten, nämlich die Transistoren M3 und M4 sowie die Dioden D1 und D2.

Bei einer praktischen Realisierung der in Fig. 1 gezeigten Schaltung ist somit der Spannungswert der Vorspannunsquelle VC so zu wählen, daß nach Abzug der zum Leiten von M5 und M6 führenden Gate-Source-Schwellenwertspannung an den Sourceanschlüssen von M5 und M6 nur noch eine für das Gate von M und für die Transistoren M3 und M4 und die Dioden D1 und D2 verträgliche Spannung übrig bleibt.

Es wird nun die Wirkungsweise der in Fig. 1 gezeigten Schaltung erläutert. Dabei wird angenommen, daß an OUT eine kapazitive Last angeschlossen ist, beispielsweise das Gate eines hochpotentialseitigen MOS-Schalttransistors, der mittels der Schaltvorrichtung nach Fig. 1 leitend und sperrend geschaltet werden soll. Damit die an VS angeschlossene Versorgungsspannungsquelle, beispielsweise in Form einer Ladungspumpschaltung, möglichst wenig belastet wird, soll die Schaltsteuerung leistungslos und ohne einen Spannungsabfall, wie er beispielsweise durch Dioden verursacht würde, erfolgen. Des weiteren soll die an OUT angeschlossene kapazitive Last von der Schaltvorrichtung nach Fig. 1 auch dann nicht entladen werden, wenn die an VS anliegende Versorgungsspannung bis in den Bereich der über der kapazitiven Last und damit an OUT auftretenden Last abfällt oder gar darunter.

Das EIN/AUS-Schalten des Schalttransistors M erfolgt über ein binäres Schaltsteuersignal, das dem Steuersignaleingang C zugeführt wird. Weist das Schaltsteuersignal hohes Potential H auf, dem beispielsweise der Binärwert "1" zugeordnet ist, sind M1 leitend und M2 nicht leitend geschaltet. Da die beiden Schutztransistoren M5 und M6 immer leitend geschaltet sind, gelangt auf diese Weise an den ersten Schaltungsknoten S1 und damit über den Schaltsignalausgang A an das Gate von M niedriges Potential, bei dem es sich praktsich um Massepotential handelt. Das niedrige Potential an S1 bewirkt, daß M4 leitet, so daß an S2 hohes Potential liegt, praktisch der an VS auftretende Spannungswert. Dies führt zum Sperren von M3. Am Gate von M wird dadurch ein definiertes niedriges Potential sichergestellt, so daß M sicher leitet und von VS über M und OUT ein Ladestrom in die an OUT angeschlossene kapazitive Last fließen kann.

Dafür ist Voraussetzung, daß das Potential an VS so weit über dem über M1 und M5 an S1 durchgeschalteten Massepotential liegt, daß die Gate-Source-Spannung von M über dem Schwellenwert für das Leiten von M liegt. Unter dieser Voraussetzung leiten die Dioden D1 und D2.

Liegt am Steuersignaleingang C ein Steuersignal mit einem niedrigen Potential L bzw. mit dem Binärwert "0", sperrt M1, während M2 leitet. Damit liegt am Schaltungsknoten S2 niedriges Potential, so daß M3 leitet. Aufgrund des gleichzeitigen Sperrens von M1 und Leitens von M3 liegt der Schaltungsknoten S1 auf hohem Potential, so daß M und M4 sperren. Die Verbindung zwischen VS und OUT ist daher gesperrt.

Um M schalten zu können, muß auf der Hochpotentialseite von M5 eine schaltbare Impedanz vorhanden sein, die im Sperrzustand so hoch ist, daß am Gate von M ein ausreichend niedriges Potential L für das Leiten von M sichergestellt wird. Diese schaltbare Impedanz wird durch M3 gebildet. Um M in den Sperrzustand zu schalten, muß M3 leitend geschaltet werden. Hierfür wird der in Fig. 1 rechte Schaltsteuerzweig verwendet.

Infolge der Kreuzkoppelung von M3 und M4 durch das Verbinden von deren Gateanschlüssen mit dem Schaltungsknoten des je anderen Schaltsteuerzweiges wird ein bistabiles Verhalten der Steuerschaltung erreicht. Solange das Potential von VS ausreichend über dem Potential von OUT liegt, wird daher von der Schaltsteuerschaltung mit den ersten Transistoren M1, M2 und den zweiten Transistoren M3, M4 immer ein sicheres Schalten von M in Abhängigkeit von dem an C anliegenden binären Steuersignal sichergestellt.

Aufgrund des gegenläufigen EIN/AUS-Schaltens von M1 und M2 und als Folge der Kreuzkopplung von M3 und M4 wird erreicht, daß in jedem der beiden Schaltsteuerzweige von den beiden Transistoren M1 und M3 bzw. M2 und M4 immer einer leitend und der andere sperrend geschaltet ist. In keinem der über das Steuersignal an C gesteuerten Schaltzustände der Steuerschaltung gibt es eine leitende Verbindung zwischen VS und GND, so daß diese Steuerschaltung immer leistungslos arbeitet.

Die Dioden D1, D2 und D3 sind vorgesehen, um zu verhindern, daß der Transistor M dann, wenn das Potential an VS unter das Potential an OUT abfällt, in einen invers leitenden Zustand gelangt, obwohl er durch Anlegen eines Steuersignals mit niedrigem Potential L an den Steuersignaleingang C sperren sollte. Bei diesen Potentialverhältnissen an VS und OUT würden die parasitären Drain-Substrat-Dioden DSD von M3 und M4 leiten. Als Folge davon träte am Gate von M eine Spannung auf, die niedriger als die an OUT anliegende Spannung ist, was M in einen invers leitenden Zustand brächte und zu einer Belastung oder Entladung der an OUT liegenden kapazitiven Last führte. Die Dioden D1 und D2 verhindern diesen Effekt, indem sie sperren, wenn das an VS liegende Potential zu niedrig wird.

Wenn bei einem niedrigen Potential des Steuersignals am Steuersignaleingang C M1 sperrt und aufgrund der Tatsache, daß das an VS liegende Potential niedriger als das an OUT auftretende Potential ist, die Diode D1 sperrt, ist das Potential am Schaltungsknoten S1 und damit am Gate von M floatend oder undefiniert. Welches Potential sich am Gate von M einstellt, hängt von Effekten ab, die nicht voraussagbar sind, beispielsweise kapazitive Effekte, parasitäre Effekte, Leckströme usw.. Dies könnte dazu führen, daß M trotz der Einfügung der Diode D1 doch invers leitet. Dies wird mit Hilfe des Sicherheitstransistors M7 verhindert. Da das Gate von M7 mit VS verbunden ist, kommt es dann, wenn das Potential an VS kleiner ist als das Potential an OUT, zum inversen Leiten von M7, wodurch das an OUT liegende Potential über M7 auf den Schaltungsknoten S1 und damit an das Gate von M gelangt. Infolge dessen befinden sich Drain und Gate von M auf gleichem Potential, nämlich auf dem an OUT liegenden Potential. Dies verhindert, daß M invers leitet.

Wenn das Substrat des Transistors M mit dessen Source elektrisch verbunden wäre, wie es für einen MOS-Transistor der Normalfall ist, entstünde dann, wenn die Spannung an VS unter die Spannung an OUT absinkt, über die Drain-Source-Diode DSD des Transistors M eine leitende Verbindung zwischen VS und OUT, was zu einer Entladung der an OUT liegenden kapazitiven Last über DSD von M zu VS führen würde. Um dies zu verhindern, wird für M ein MOS-Transistor verwendet, dessen Source und Substrat elektrisch voneinander getrennt und mit getrennten elektrischen Anschlüssen versehen sind, so daß dessen Source-Substrat-Diode SSD nicht in der sonst üblichen Weise elektrisch überbrückt ist. Da von der parasitären Diode SSD von M die Anode zu VS weist, diese parasitäre Diode SSD also nicht leitet, wenn das Potential an VS unter das Potential von OUT abfällt, bildet diese parasitäre Diode eine Sperre gegen eine Entladung der kapazitiven Last an OUT nach VS.

Die Diode D3 ist vorgesehen, damit bei einem Abfall des Potentials von VS unter das Potential von OUT nicht trotz elektrischer Trennung von Source und Substrat des Transistors M das Potential von VS an den Drainanschluß von M gelangt, und zwar über die parasitäre Drain-Substrat-Diode DSD. Bei derartigen Potentialverhältnissen an VS und OUT sperrt die Diode D3. Ein Entladungsweg für die an OUT angeschlossene kapazitive Last zum Versorgungsspannungseingang VS ist somit sicher unterbunden.

Würde man für den Sicherheitstransistor M7 einen MOS-Transistor verwenden, bei dem in üblicher Weise Substrat und Source elektrisch miteinander verbunden sind, würde es dann, wenn das Steuersignal am Steuersignaleingang C hohes Potential aufweist und aufgrund des Leitens von M1 in etwa Massepotential am Schaltungsknoten S1 liegt, über die parasitäre Drain-Substrat-Diode DSD von M7 zu einer leitenden Verbindung zwischen OUT und GND kommen, was zu einer Entladung der an OUT angeschlossenen kapazitiven Last zu GND (Masse) führen würde. Dies wird dadurch verhindert, daß auch für M7 ein MOS-Transistor verwendet wird, bei dem Source und Substrat elektrisch voneinander getrennt und mit getrennten elektrischen Anschlüssen versehen sind. Die sich dadurch elektrisch auswirkende parasitäre Substrat-Source-Diode SSD von M7 kann daher eine Sperre gegen eine leitende Verbindung zwischen OUT und GND bilden.

Wäre der separat von der Sourcezone kontaktierte Substrat- oder Bulk-Bereich von M7 direkt mit OUT verbunden, geriete die parasitäre Source-Substrat-Diode SSD von M7 in den leitenden Zustand, wenn das Potential an OUT zu negativ wird. Es könnte dann zu parasitären Effekten kommen, die sich nachteilig auf die an OUT angeschlossenen Schaltungen auswirken könnten. Dies wird durch Anordnung der Diode D4 vermieden. Die Dioden D3 und D4, mittels welchen die separat kontaktierten Source- und Bulk-Bereiche von M und M7 mit VS bzw. OUT verbunden sind, sind vorzugsweise Schottky-Dioden, weil diese eine niedrigere Durchlaßschwellenspannung als PN-Dioden aufweisen. Würde man beispielsweise für D3 eine PN-Diode verwenden, läge der separat kontaktierte Source-Bereich von M auf einem Potential, das um eine PN-Dioden-Durchlaßspannung niedriger ist als das Potential von VS. Damit könnte die parasitäre Source-Substrat-Diode SSD von M unerwünscht leiten. Da aber die Schottky-Dioden-Durchlaßspannung von D3 niedriger ist als die PN-Dioden-Durchlaßspannung der parasitären Source-Substrat-Diode SSD von M, ist die Spannungsdifferenz zwischen Source und Substrat bzw. Bulk von M zu niedrig, um SSD in den leitenden Zustand zu bringen.

Aus gleichen Überlegungen wird für D4 eine Schottky-Diode verwendet.

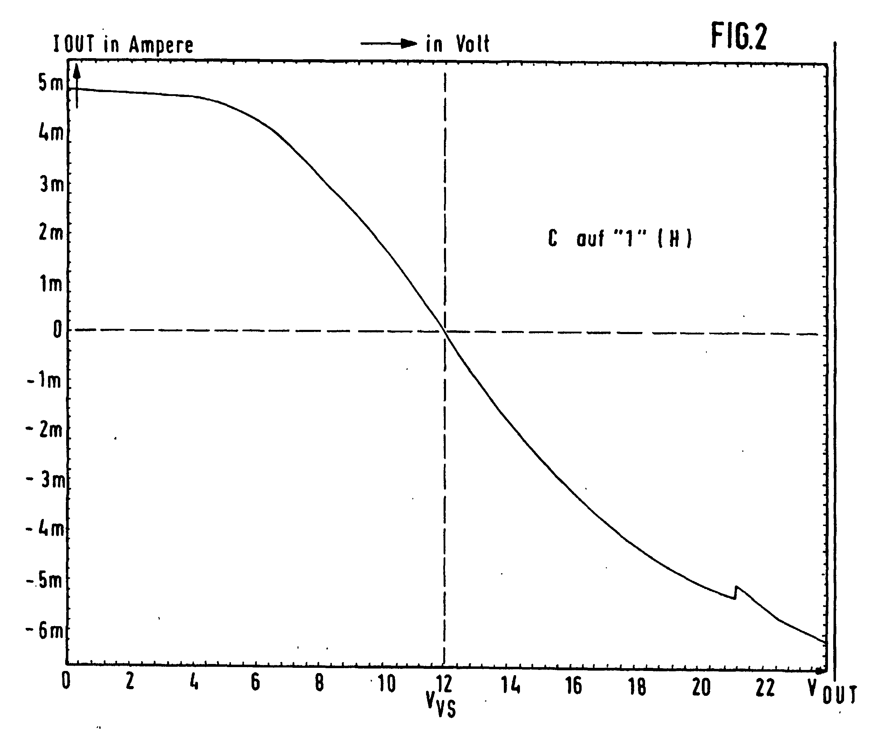

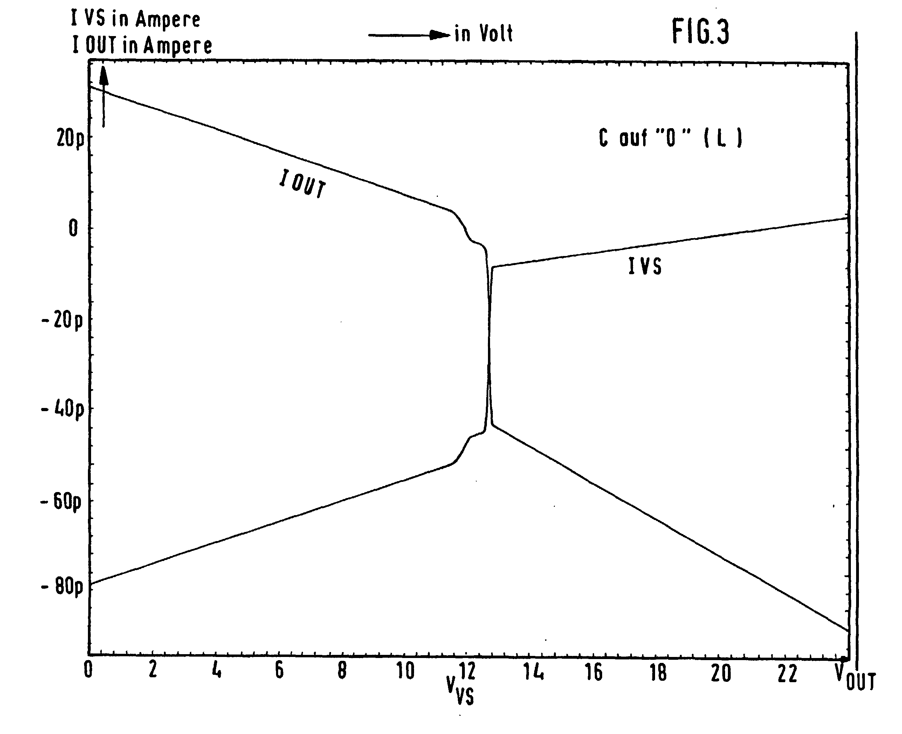

Die Fig. 2 und 3 zeigen Impedanzkennlinien der in Fig. 1 dargestellten Schaltvorrichtung. Fig. 2 zeigt eine Impedanzkennlinie für den Fall, daß am Steuersignaleingang C hohes Potential H oder ein Binärwert "1" liegt, der Schalttransistor M somit leitend geschaltet ist. Fig. 3 zeigt Impedanzkennlinien für den Fall, daß am Steuersignaleingang C niedriges Potential L oder der Binärwert "0" anliegt und der Schalttransistor M daher sperren soll. Die Fig. 2 und 3 zeigen Ströme in Abhängigkeit von der am Lastausgang OUT liegenden Spannung V_{OUT}. Fig. 2 zeigt den infolge des Leitens von M am Lastanschluß OUT fließenden Strom I_{OUT}. Fig. 3 zeigt den bei sperrend geschaltetem Schalttransistor M am Lastausgang OUT fließenden Strom I_{OUT} und den bei sperrendem M am Versorgungsspannungseingang S fließenden Strom I_{VS}.

Aus Fig. 2 ist entnehmbar, daß die Schaltvorrichtung gemäß Fig. 1 bei Spannungswerten von V_{OUT}, die im Bereich der am Versorgungsspannungseingang VS liegenden Spannung V_{VS} liegen, sich wie ein linearer Widerstand verhält und in Abhängigkeit davon, ob V_{OUT} größer oder kleiner als V_{VS} ist, Strom in der einen oder der anderen Richtung leitet. In diesem mittleren Bereich der Impedanzkennlinie von Fig. 2 verhält sich die Schaltvorrichtung nach Fig. 1 also wie ein mechanischer elektrischer Schalter.

Fig. 3 zeigt, daß bei gesperrtem M sowohl für den Lastanschluß OUT als auch für den Versorgungsspannungseingang VS gesehen nur sehr kleine Ströme im pA-Bereich fließen, praktisch also kein Strom fließt, die Schaltvorrichtung nach Fig. 1 also praktisch sperrt.

Die erfindungsgemäße Schaltvorrichtung läßt sich überall dort vorteilhaft einsetzen, wo im leitend geschalteten Zustand ein geringer Spannungsabfall, ein hoher Schutz gegen Leiten im gesperrten Zustand und ein möglichst geringer Leistungsverbrauch gefragt sind. Mit solchen Eigenschaften eignet sich die erfindungsgemäße Schaltvorrichtung beispielsweise besonders für geschaltete Gleichrichter, Ladungspumpschaltungen und ganz allgemein für hochpotentialseitige Schalter mit niedrigem Leistungsbedarf, wie sie z. B. im Automobilbereich benötigt werden.

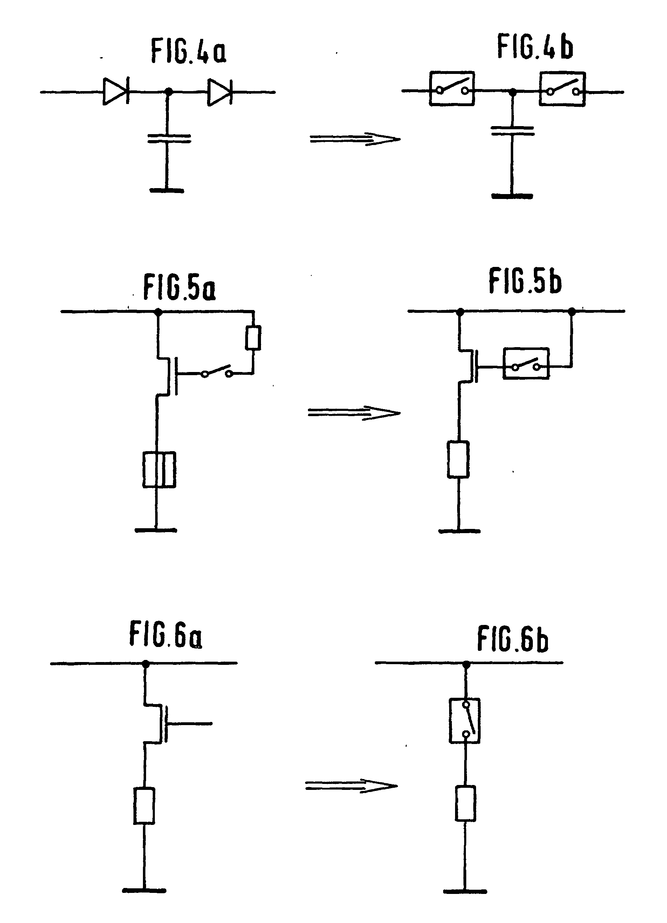

In den Fig. 4a bis 6b sind einige Einsatzmöglichkeiten für die erfindungsgemäße Schaltvorrichtung schematisch angedeutet. Die mit a bezeichneten Figuren zeigen herkömmliche Schaltungen, während die mit b bezeichneten Figuren mit der erfindungsgemäßen Schaltvorrichtung aufgebaute Schaltungen gleicher Grundfunktion darstellen, wobei das Schaltsymbol des in einem Rechteckblock untergebrachten Schalters je eine erfindungsgemäße Schaltvorrichtung bedeutet.

Die Fig. 4a und 4b zeigen je eine Ladungspumpschaltung mit einem Dioden verwendeten herkömmlichen Aufbau bzw. mit einem erfindungsgemäße Schaltvorrichtungen verwendenden neuen Aufbau. Fig. 5a und 5b zeigen eine Steuereinrichtung für das Schalten eines hochpotentialseitigen MOS-Transistors mit herkömmlicher Schaltvorrichtung bzw. erfindungsgemäßer Schaltvorrichtung. Die Fig. 6a und 6b zeigen einen hochpotentialseitigen Schalter in herkömmlichem Aufbau mit einem MOS-Transistor und in neuem Aufbau mit einer erfindungsgemäßen Schaltvorrichtung.

## Patentansprüche

1. Elektrische Schaltvorrichtung
a. mit einer einen Schaltsteueranschluss aufweisenden Schaltereinrichtung (M);
b. mit einer zwischen einen ersten Spannungsquellenanschluss (VS) und einen zweiten Spannungsquellenanschluss (GND) einer Spannungsquelle geschalteten Steuerschaltung, die
b.1 einen mit einem binären Schaltsteuersignal beaufschlagbaren Steuersignaleingang (C) und einen auf den Schaltsteueranschluss der Schaltereinrichtung (M) wirkenden Schaltsignalausgang (A) aufweist und
b.2 zwei zueinander parallel geschaltete Steuerschaltungszweige enthält,
b.3 die je eine Reihenschaltung mit einem ersten Schalter (M1, M2), einem für den ersten Schalter (M1, M2) als schaltbare Lastimpedanz dienenden zweiten Schalter (M3, M4) und einem zwischen erstem Schalter (M1, M2) und zweitem Schalter (M3, M4) befindlichen Schaltungsknoten (S1, S2) aufweisen;
wobei: .
c. der Schaltsignalausgang (A) mit dem einen (S1) der beiden Schaltungsknoten (S1, S2) verbunden ist;
d. die zweiten Schalter (M3, M4) je einen Lastimpedanzschaltsteueranschluss aufweisen und dadurch kreuzgekoppelt sind, dass deren Lastimpedanzschaltsteueranschlüsse mit dem Schaltungsknoten (S1, S2) des je anderen Steuerschaltungszweiges verbunden sind;
e. die ersten Schalter (M1, M2) mittels des Schaltsteuersignals gegenläufig leitend und sperrend schaltbar sind, derart, dass dann, wenn einer der beiden ersten Schalter (M1, M2) leitend geschaltet ist, der jeweils andere erste Schalter (M1, M2) sperrend geschaltet ist und umgekehrt; und
f. die zweiten Schalter (M3, M4) aufgrund ihrer Kreuzkopplung miteinander und aufgrund ihrer Reihenschaltung mit den ersten Schaltern (M1, M2)
f.1 einerseits gegenläufig zueinander leitend und sperrend schaltbar sind, derart, dass dann, wenn einer der beiden zweiten Schalter leitend geschaltet ist, der jeweils andere zweite Schalter (M3, M4) sperrend geschaltet ist und umgekehrt,
f.2 und andererseits gegenläufig zu den ersten Schaltern (M1, M2) leitend und sperrend schaltbar sind, derart, dass in jedem Steuerschaltungszweig dann, wenn dessen erster Schalter (M1, M2) leitend geschaltet ist, dessen zweiter Schalter (M3, M4) sperrend geschaltet ist und umgekehrt,
g. in jedem der beiden Steuerschaltungszweige zwischen dem Schaltungsknoten (S1, S2) und dem ersten Schalter (M1, M2) die Hauptstrecke eines eine Steuerelektrode aufweisenden Schutztransistors (M5, M6) angeordnet ist, deren Steuerelektroden gemeinsam über eine Vorspannungsquelle (VC) mit dem ersten Spannungsquellenanschluss (VS) verbunden sind,
h. und der Vorspannungswert der Vorspannungsquelle (VC) derart bemessen ist, dass die beiden Schutztransistoren (M5, M6) immer leiten und an deren zum jeweiligen Schaltungsknoten (S1, S2) weisender Seite daher immer ein Spannungswert auftritt, der maximal so hoch ist wie die Differenz zwischen dem Spannungswert der Vorspannungsquelle (VC) und der Schwellenwertspannung der Schutztransistoren (M5, M6), und
i. die Schaltereinrichtung (M) und die ersten und zweiten Schalter (M1 - M4) je durch einen Schalttransistor gebildet sind,
**dadurch gekennzeichnet, dass**
zwischen den Schaltsteueranschluss der Schaltereinrichtung (M) und einem Lastanschluss (OUT) für eine zu schaltende Last die Hauptstrecke eines Sicherheitstransistors (M7) geschaltet ist, dessen Steuerelektrode an den ersten Spannungsquellenanschluss (VS) angeschlossen ist und der ein inverses Leiten des die Schaltereinrichtung (M) bildenden MOS-Transistors verhindert.

2. Schaltvorrichtung nach Anspruch 1,
bei welcher die Schaltereinrichtung (M) und die Schalter je durch einen MOS-Transistor gebildet und der die Schaltereinrichtung (M) bildende MOS-Transistor und die die zweiten Schalter (M3, M4) bildenden MOS-Transistoren von einem ersten Kanaltyp und die die ersten Schalter (M1, M2) bildenden MOS-Transistoren vom entgegengesetzen Kanaltyp sind.

3. Schaltvorrichtung nach Anspruch 1 oder 2,
bei welcher ein Steueranschluss eines (M1) der beiden ersten Schalter (M1, M2) direkt und ein Steueranschluss des anderen (M2) der beiden ersten Schalter (M1, M2) über einen Inverter (INV) mit dem Steuersignaleingang verbunden ist.

4. Schaltvorrichtung nach einem der Ansprüche 1 bis 3,
bei welcher die Schutztransistoren (M5, M6) je durch einen MOS-Transistor mit einer Gateelektrode als Steuerelektrode gebildet und vom selben Kanaltyp wie die die Schaltereinrichtung (M) und die zweiten Schalter (M3, M4) bildenden MOS-Transistoren sind.

5. Schaltvorrichtung nach einem der Ansprüche 1 bis 3,
bei welcher in jedem der beiden Steuerschaltungszweige zwischen dem zweiten Schalter (M3, M4) und dem ersten Spannungsquellenanschluss (VS) eine Diode (D1, D2) angeordnet ist, deren Anode zu demjenigen der beiden Spannungsquellenanschlüsse (VS, GND) weist, dessen Potential positiv bezüglich des anderen der beiden Spannungsquellenanschlüsse (VS, GND) ist.

6. Schaltvorrichtung nach einem der Ansprüche 1 bis 5,
bei welcher die Schaltstrecke der Schaltereinrichtung (M) zwischen den ersten Spannungsquellenanschluss (VS) und dem Lastanschluss (OUT) für eine zu schaltende Last geschaltet ist.

7. Schaltvorrichtung nach Anspruch 6,
bei welcher von dem die Schaltereinrichtung (M) bildenden MOS-Transistor der Sourcekontakt und der Substratkontakt elektrisch voneinander getrennt sind, wobei der Substratkontakt über eine dritte Diode (D3) mit dem ersten Spannungsquellenanschluss (VS) verbunden ist und die Anode der dritten Diode (D3) zu demjenigen der beiden Spannungsquellenanschlüsse (VS, GND) weist, dessen Potential positiv bezüglich des anderen der beiden Spannungsquellenanschlüsse (VS, GND) ist.

8. Schaltvorrichtung nach Anspruch 7,
bei welcher die dritte Diode (D3) durch eine Schottky-Diode gebildet ist.

9. Schaltvorrichtung nach Anspruch 1,
bei welcher der Sicherheitstransistor (M7) durch einen MOS-Transistor gebildet ist, dessen Sourcekontakt und dessen Substratkontakt elektrisch voneinander getrennt sind, wobei der Substratkontakt über eine vierte Diode (D4) mit dem ersten Spannungsquellenanschluss (VS) verbunden ist und die Anode der vierten Diode (D4) zu dem Lastanschluss (OUT) weist.

10. Schaltvorrichtung nach Anspruch 9,
bei welcher die vierte Diode (D4) durch eine Schottky-Diode gebildet ist.

11. Schaltvorrichtung nach einem der Ansprüche 1 bis 10 als Schaltungseinrichtung in einer Ladungspumpschaltung zur Erzeugung einer Pumpsspannung, deren Pumpspannungswert größer ist als der Spannungswert einer die Ladungspumpschaltung speisenden Versorgungsspannungsquelle, mit einer T-Schaltung, die in an sich bekannter Weise eine Reihenschaltung mit zwei Schaltungseinrichtungen und einen einen Endes an einen Verbindungspunkt zwischen den beiden Schaltungseinrichtungen angeschlossenen Pumpkondensator aufweist.

12. Schaltvorrichtung nach einem der Ansprüche 1 bis 10 als Schaltsteuervorrichtung zum Steuern des Leitend- und Sperrend-Schaltens eines auf der Seite hohen Potentials einer zu schaltenden Last befindlichen MOS-Schalttransistors, dessen nicht mit der Last verbundene Hauptstreckenelektrode mit einem Versorgungsspannungsanschluss verbunden ist und dessen Gate zum Leitend-Schalten des MOS-Schaltungstransistors eine Gatespannung benötigt, die über dem Spannungswert des Versorgungsspannungsanschlusses liegt, wobei der Spannungsquellenanschluss (VS) durch einen Pumpspannungsausgang einer Ladungspumpschaltung gebildet wird.

13. Schaltvorrichtung nach einem der Ansprüche 1 bis 10 als Schalter auf der Seite hohen Potentials einer zu schaltenden Last.

## Claims

1. An electrical switching device comprising
a. a switch means (M) having a switching control terminal;
b. a control circuit which is connected between a first voltage source terminal (VS) and a second voltage source terminal (GND) and which
b.1 has a control signal input (C) adapted to have a binary switching control signal applied thereto and a switching signal output (A) acting on the switching control terminal of the switch means (M), and
b.2 contains two control circuit branches connected in parallel to each other,
b.3 each having a series connection including a first switch (M1, M2), a second switch (M3, M4) serving as switchable load impedance for the first switch (M1, M2), and a circuit node (S1, S2) located between first switch (M1, M2) and second switch (M3, M4);
in which:
c. the switching signal output (A) is connected to one (S1) of the two circuit nodes (S1, S2);
d. the second switches (M3, M4) each have a load impedance switching control terminal and are cross-coupled in that the load impedance switching control terminals are connected to the circuit node (S1, S2) of the respective other control circuit branch;
e. the first switches (M1, M2) are switchable to the conducting and to the blocking state in opposite manner by means of the switching control signal such that, when one of said two first switches (M1, M2) is switched to the conducting state, the respective other first switch (M1, M2) is switched to the blocking state, and vice versa; and
f. the two switches (M3, M4), due to the cross-coupling with each other and due to their series connection with the first switches (M1, M2),
f.1 are switchable on the one hand to the conducting state and to the blocking state in opposite manner to each other, such that, when one of the two second switches is switched to the conducting state, the respective other second switch (M3, M4) is switched to the blocking state, and vice versa,
f.2 and are switchable on the other hand to the conducting state and to the blocking state in opposition to the first switches (M1, M2), such that in each control circuit branch, when the first switch (M1, M2) thereof is switched to the conducting state, the second switch (M3, M4) thereof is switched to the blocking state, and vice versa,
g. in each of the two control circuit branches, between the circuit node (S1, S2) and the first switch (M1, M2), there is disposed the main path of a protective transistor (M5, M6) having a control electrode, with said control electrodes being commonly connected via a bias voltage source (VC) to the first voltage source terminal (VS),
h. and the bias voltage value of the bias voltage source (VC) is dimensioned such that the two protective transistors (M5, M6) are always conducting and, thus, at the side thereof facing the respective circuit node (S1, S2), there is always a voltage value which at the most is as large as the difference between the voltage value of the bias voltage source (VC) and the threshold voltage of the protective transistors (M5, M6), and
i. the switch means (M) and the first and second switches (M1 to M4) are each constituted by a switching transistor,
**characterized in that**
the main path of a safety transistor (M7) is connected between the switching control terminal of the switch means (M) and a load terminal (OUT) for a switchable load, with said safety transistor (M7) having its control electrode connected to the first voltage source terminal (VS) and preventing inverse conduction of the MOS transistor constituting the switch means (M).

2. A switching device according to claim 1,
wherein the switch means (M) and the switching transistors are each constituted by a MOS transistor and the MOS transistor constituting the switch means (M) as well as the MOS transistors constituting the second switches (M3, M4) are of a first channel type and the MOS transistors constituting the first switches (M1, M2) are of the opposite channel type.

3. A switching device according to claim 1 or 2,
wherein a control terminal of one (M 1) of the two first switches (M 1, M2) is directly connected to the control signal input and a control terminal of the other (M2) of the two first switches is connected thereto via an inverter (INV).

4. A switching device according to any of claims 1 to 3,
wherein the protective transistors (M5, M6) are each constituted by a MOS transistor having a gate electrode as control electrode and are of the same channel type as the MOS transistors constituting the switch means (M) and the second switches (M3, M4).

5. A switching device according to any of claims 1 to 3,
wherein in each of the two control circuit branches there is disposed, between the second switch (M3, M4) and the first voltage source terminal (VS), a diode (D1, D2) having its anode directed towards that one of the two voltage source terminals (VS, GND) whose potential is positive with respect to the other one of the two voltage source terminals (VS, GND).

6. A switching device according to any of claims 1 to 5,
wherein the switching path of the switch means (M) is connected between the first voltage source terminal (VS) and the load terminal (OUT) for a switchable load.

7. A switching device according to claim 6,
wherein the switch means (M) is constituted by a MOS transistor whose source contact and substrate contact are electrically isolated from each other, with the substrate contact being connected via a third diode (D3) to the first voltage source terminal (VS) and the anode of the third diode (D3) being directed towards that one of the two voltage source terminals (VS, GND) whose potential is positive with respect of the other one of the two voltage source terminals (VS, GND).

8. A switching device according to claim 7,
in which the third diode (D3) is constituted by a Schottky diode.

9. A switching device according to claim 1,
wherein the safety transistor (M7) is constituted by a MOS transistor whose source contact and substrate contact are electrically isolated from each other, with the substrate contact being connected to the first voltage source terminal (VS) via a fourth diode (D4) and the anode of the fourth diode (D4) being directed towards the load terminal (OUT).

10. A switching device according to claim 9,
wherein the fourth diode (D4) is constituted by a Schottky diode.

11. A switching device according to any of claims 1 to 10 as a switching means in a charge pumping circuit for producing a pumping voltage whose pumping voltage value is higher than the voltage value of a supply voltage source feeding the charge pumping circuit, comprising a T-connected circuit having, in a manner known per se, a series connection having two circuit means and a pumping capacitor connected at one end to a connecting point between the two circuit means.

12. A switching device according to any of claims 1 to 10 as a switching control device for controlling switching of a MOS switching transistor to the conducting state and to the blocking state, said MOS transistor being disposed on the side of high potential of a switchable load and having its main path electrode, which is not connected to the load, connected to a supply voltage terminal and the gate thereof requiring a gate voltage that is above the voltage value of the supply voltage terminal in order to switch the MOS switching transistor to the conducting state, with the voltage source terminal (VS) being constituted by a pumping voltage output of a charge pumping circuit.

13. A switching device according to any of claims 1 to 10 as a switch disposed on the side of high potential of a switchable load.

## Revendications

1. Dispositif de commutation électrique
a. avec un équipement à commutateurs (M) comportant un raccord de commande de commutation ;
b. avec un circuit de commande couplé entre un premier raccord de source de tension (VS) et un deuxième raccord de source de tension (GND) d'une source de tension, lequel
b. 1 comporte une entrée de signal de commande (C) pouvant recevoir un signal de commande de commutation binaire et une sortie de signal de commutation (A) agissant sur le raccord de commande de commutation de l'équipement à commutateurs (M), et
b.2 contient deux branches du circuit de commande couplées en parallèle l'une à l'autre,
b.3 qui comportent chacune un circuit série avec un premier commutateur (M1, M2), un deuxième commutateur (M3, M4) servant d'impédance de charge commutable au premier commutateur (M1, M2), et un noeud de circuit (S1, S2) se trouvant entre le premier commutateur (M1, M2) et le deuxième commutateur (M3, M4) ;
dans lequel
c. la sortie de signal de commutation (A) est reliée à l'un (S1) des deux noeuds de circuit (S1, S2),
d. les deuxièmes commutateurs (M3, M4) comportent chacun un raccord de commande de commutation de l'impédance de charge et sont couplés croisés par le fait que leurs raccords de commande de commutation d'impédance de charge sont reliés au noeud de circuit (S1, S2) de l'autre branche du circuit de commande ;
e. les premiers commutateurs (M1, M2) peuvent être couplés conducteurs en sens contraire et non conducteurs, au moyen du signal de commande de commutation, de manière que lorsque l'un des deux premiers commutateurs (M1, M2) est couplé conducteur, l'autre premier commutateur (M1, M2) est couplé non conducteur et inversement ; et
f. en raison de leur couplage croisé entre eux et en raison de leur circuit série avec les premiers commutateurs (M1, M2), les deuxièmes commutateurs (M3, M4)
f.1 peuvent être couplés d'une part conducteurs en sens contraire et non conducteurs, de manière que lorsque l'un des deux deuxièmes commutateurs est couplé conducteur, l'autre deuxième commutateur (M3, M4) est couplé non conducteur et inversement,
f.2 et d'autre part, ils peuvent être couplés, en sens contraire aux premiers commutateurs (M1, M2) conducteurs et non conducteurs, de manière que dans chaque branche du circuit de commande lorsque son premier commutateur (M1, M2) est couplé conducteur, son deuxième commutateur (M3, M4) est couplé non conducteur et inversement,
g. dans chacune des deux branches du circuit de commande, entre le noeud de circuit (S1, S2) et le premier commutateur (M1, M2), est prévue la voie principale d'un transistor de protection (M5, M6) comportant une électrode de commande, dont les électrodes de commande sont reliées ensemble, par une source de polarisation (VC), au premier raccord de la source de tension (VS),
h. et la valeur de la tension de polarisation de la source de tension de polarisation (VC) est telle que les deux transistors de protection (M5, M6) sont toujours conducteurs et, sur leur côté dirigé vers le noeud de circuit (S1, S2) respectif, apparaît donc toujours une valeur de tension qui au maximum est égale à la différence entre la valeur de la tension de la source de polarisation (VC) et la tension de valeur de seuil des transistors de protection (M5, M6) et
i. l'équipement à commutateurs (M) et les premiers et deuxièmes commutateurs (M1-M4) sont formés chacun par un transistor de commutation,
**caractérisé en ce que**
entre le raccord de commande de commutation de l'équipement à commutateurs (M) et un raccord de charge (OUT) pour une charge à commander, est couplée la voie principale d'un transistor de sécurité (M7) dont l'électrode de commande est reliée au premier raccord de la source de tension (VS) et empêche une conduction inverse du transistor (MOS) formant l'équipement à commutateurs (M).

2. Dispositif de commutation selon la revendication 1, dans lequel l'équipement à commutateurs (M) et les commutateurs sont formés chacun par un transistor (MOS) et le transistor (MOS) formant l'équipement à commutateurs (M), et les transistors (MOS) formant les deuxièmes commutateurs (M3, M4) sont d'un premier type de canal, et les transistors (MOS) formant les premiers commutateurs (M1, M2) sont du type de canal opposé.

3. Dispositif de commutation selon la revendication 1 ou 2, dans lequel un raccord de commande de l'un (M1) des deux premiers commutateurs (M1, M2) est relié directement et un raccord de commande de l'autre (M2) des premiers commutateurs (M1, M2) est relié par un inverseur (INV) à l'entrée de signal de commande.

4. Dispositif de commutation selon l'une des revendications 1 à 3, dans lequel les transistors de protection (M5, m6) sont formés chacun par un transistor (MOS) avec une électrode de porte comme électrode de commande, et sont du même type de canal que l'équipement à commutateurs (M) et les transistors (MOS) formant les deuxièmes commutateurs (M3, M4).

5. Dispositif de commutation selon l'une des revendications 1 à 3, dans lequel dans chacune des deux branches du circuit de commande, entre le deuxième commutateur (M3, M4) et le premier raccord de source de tension (VS), est disposée une diode (Dl, D2) dont l'anode est dirigée vers celui des deux raccords de source de tension (VS, GND) dont le potentiel est positif par rapport à l'autre des deux raccords de source de tension (VS, GND).

6. Dispositif de commutation selon l'une des revendications 1 à 5, dans lequel la voie de commutation de l'équipement à commutateurs (M) est couplée entre le premier raccord de source de tension (VS) et le raccord de charge (OUT) pour une charge à commander.

7. Dispositif de commutation selon la revendication 6, dans lequel le contact source et le contact substrat du transistor (MOS) formant l'équipement à commutateurs (M), sont séparés électriquement l'un de l'autre, le contact substrat étant relié par une troisième diode (D3) au premier raccord de source de tension (VS), et l'anode de la troisième diode (D3) est dirigée vers celui des deux raccords de source de tension (VS, GND) dont le potentiel est positif par rapport à l'autre des deux raccords de sources de tension (VS, GND).

8. Dispositif de commutation selon la revendication 7, dans lequel la troisième diode (D3) est formée par une diode schottky.

9. Dispositif de commutation selon la revendication 1, dans lequel le transistor de sécurité (MS) est formé par un transistor (MOS) dont le contact source et le contact substrat sont séparés électriquement l'un de l'autre, le contact source étant relié, par une quatrième diode (D4), au premier raccord de source de tension (VS), et l'anode de la quatrième diode (D4) étant dirigée vers le raccord de charge (OUT).

10. Dispositif de commutation selon la revendication 9, dans lequel la quatrième diode (D4) est formée par une diode schottky.

11. Dispositif de commutation selon l'une des revendications 1 à 10 servant d'équipement de circuit dans un circuit de pompage de charge pour produire une tension de pompage dont la valeur est supérieure à la valeur de la tension d'une source de tension d'alimentation alimentant le circuit de pompage de charge, comportant un circuit en T qui comprend, de manière connue, un circuit série avec deux équipements de circuit et un condensateur de pompage raccordé à une extrémité à un point de liaison entre les deux équipements de circuit.

12. Dispositif de commutation selon l'une des revendications 1 à 10 servant de dispositif de commande de commutation pour commander la commutation conductrice - et non conductrice - d'un transistor de commutation (MOS) se trouvant sur le côté haut potentiel d'une charge à commander, dont l'électrode de voie principale, non reliée à la charge, est reliée à un raccord de tension d'alimentation, et dont la porte pour la commande conductrice du transistor à circuit (MOS), a besoin d'une tension de porte qui est supérieure à la valeur de la tension du raccord de tension d'alimentation, le raccord de source de tension (VS) étant formé par une sortie de tension de pompage d'un circuit de pompage de charge.

13. Dispositif de commutation selon l'une des revendications 1 à 10, servant de commutateur sur le côté haut potentiel d'une charge à commander.
